(19) Europäisches Patentamt
European Patent Office
Office européen des brevets

(11) Veröffentlichungsnummer: **0 233 567 B1**

(12) **EUROPÄISCHE PATENTSCHRIFT**

(45) Veröffentlichungstag der Patentschrift: **27.05.92**

(51) Int. Cl.[5]: **C08K 5/43**, C09D 163/00, G03F 7/004, C08G 59/68, C08L 61/06

(21) Anmeldenummer: **87101731.5**

(22) Anmeldetag: **09.02.87**

# (54) Härtbare Mischungen, enthaltend N-Sulfonylaminosulfoniumsalze als kationisch wirksame Katalysatoren.

(30) Priorität: **14.02.86 DE 3604580**

(43) Veröffentlichungstag der Anmeldung: **26.08.87 Patentblatt 87/35**

(45) Bekanntmachung des Hinweises auf die Patenterteilung: **27.05.92 Patentblatt 92/22**

(84) Benannte Vertragsstaaten: **BE CH ES FR GB IT LI NL SE**

(56) Entgegenhaltungen:
**EP-A- 0 054 509**
**EP-A- 0 132 710**

(73) Patentinhaber: **BASF Aktiengesellschaft**
**Carl-Bosch-Strasse 38**
**W-6700 Ludwigshafen(DE)**

(72) Erfinder: **Henne, Andreas, Dr.**
**Adolph-Kolping-Strasse 137a**
**W-6730 Neustadt(DE)**
Erfinder: **Ochs, Wolfram, Dr.**
**H.-Willmann-Strasse 6**
**W-6706 Wachenheim(DE)**
Erfinder: **Tesch, Helmut, Dr.**
**Goethestrasse 12**
**W-6701 Birkenheide(DE)**
Erfinder: **Schornick, Gunnar, Dr.**
**Dr.-Konrad-Adenauer-Strasse 8**
**W-6719 Neuleiningen(DE)**
Erfinder: **Leyrer, Reinhold J., Dr.**
**Menzelstrasse 4**
**W-6700 Ludwigshafen(DE)**

EP 0 233 567 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft kationisch härtbare Mischungen, die als Katalysator ein N-Sulfonylaminosulfoniumsalz enthalten, durch Erhitzen oder Bestrahlung mit aktinischem Licht gehärtet werden können und sich zur Herstellung von Formkörpern, Beschichtungen, Reliefbildern und Resistmustern eignen.

Kationisch härtbare Mischungen wie Epoxidharze werden üblicherweise mit Carbonsäuren oder deren Anhydriden oder durch Zusatz von anderen Lewis-Säuren gehärtet. Wegen der hohen Reaktivität müssen beide Komponenten getrennt gehandhabt und nach dem Vermischen rasch verarbeitet werden. Es hat nicht an Versuchen gefehlt, Einkomponentensysteme zu entwickeln, die längere Zeit lagerstabil sind und entweder durch Erhitzen oder durch Bestrahlung mit Licht geeigneter Wellenlänge gehärtet werden können. Als Katalysatoren für die durch Licht induzierte Härtung wurde eine Vielzahl von Photoinitiatoren beschrieben, unter denen vor allem die Diazoniumsalze der US-A 3 205 157 und 3 708 296 sowie die Oniumsalze von Elementen der V. (siehe DE-A 2 518 656), VI. (siehe DE-A 2 518 652, DE-A 2 904 626) und VII. (siehe DE-A 2 518 639) Hauptgruppen des Periodensystems der Elemente sowie die in den EP-A 22 081, 35 969 und 44 274 genannten Sulfoxoniumsalze genannt seien. Diese Verbindungen sind jedoch in ihren Eigenschaften nicht befriedigend. Diazoniumsalze setzen bei der Bestrahlung Stickstoff frei, was zu einer Blasenbildung in mit Diazoniumsalzen hergestellten Beschichtungen und Formkörpern führen kann. Die Jodoniumsalze der DE-A 2 518 639 sind toxisch, ebenso wie die Oniumsalze der DE-A 2 518 652 und DE-A 2 904 626 absorbieren sie zudem im Wellenlängenbereich zwischen 300 - 400 nm nur schwach, so daß den photohärbaren Gemischen meist ein Sensibilisator zugesetzt werden muß. Ferner setzen manche der Oniumsalze nach DE-A 2 518 652 und DE-A 2 904 626 bei der Bestrahlung mit aktinischem Licht übelriechende niedermolekulare Schwefelverbindungen frei. Die Sulfoxoniumsalze der EP-A 22 081, 35 969 und 44 274 sind nur umständlich unter Verwendung teurer metallorganischer Reagenzien zugänglich, was ihre Herstellung in technischen Mengen erschwert.

Als Katalysatoren für thermisch härtbare Systeme wurde in der DE-A 2 853 886 eine Kombination aus Jodonium-Salz und $Cu^{I}$ -Salz beschrieben, die jedoch wegen des stark toxischen Jodonium-Salzes nur unter erheblichen Vorsichtsmaßnahmen eingesetzt werden kann. Eine weitere Katalysatorkombination ist die in der DE-A 3 135 636 beschriebene Mischung aus Pyryliumsalzen und Metallchelaten; jedoch läßt die Lagerstabilität der mit Hilfe dieser Initiatorkombination hergestellten Mischungen Wünsche offen.

Der Erfindung lag die Aufgabe zugrunde, kationisch härtbare Mischungen zu entwickeln, die einen kationisch wirksamen Härtungskatalysator enthalten, gut lagerfähig, leicht handhabbar, verarbeitungsfähig und nicht toxisch sind, und die nach der Härtung Formkörper mit guter Oberfläche und Lösungsmittelbeständigkeit ergeben.

Gegenstand der vorliegenden Erfindung sind härtbare Mischungen enthaltend

a) eine Verbindung bzw. ein Gemisch von Verbindungen, die unter dem Einfluß eines kationischen Katalysators in eine höhermolekulare Verbindung bzw. ein Harz überführbar sind und

b) eine als Härtungskatalysator wirksame Menge eines N-Sulfonylaminosulfoniumsalzes der Formel (I)

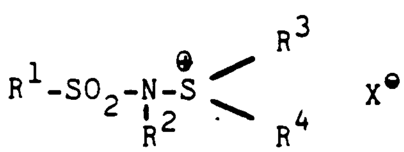

(I)

worin $R^1$ ein verzweigter oder geradkettiger $C_1$ -$C_{18}$-Alkylrest, ein 5- oder 6-Ring-Cycloalkylrest, d.h. ein Cycloalkylrest mit 5 oder 6 C-Atomen als Ringglieder, oder ein gegebenenfalls durch Chlor- oder Bromatome, $C_1$ - $C_6$-Alkyl-, $C_1$-$C_6$-Alkoxy-oder $C_1$-$C_6$-Alkylthiogruppen, Carboxyl- oder Alkoxycarbonylgruppen substituierter Phenylrest ist,

$R^2$ ein $C_1$ - $C_6$-Alkyl-, ein 5- oder 6-Ring- Cycloalklrest (siehe oben), ein aliphatischer $C_1$ -$C_6$-Acyl- oder ein gegebenenfalls substituierter Benzoylrest ist,

$R^3$ und $R^4$ die gleiche Bedeutung wie $R^1$ haben, wobei $R^1$, $R^3$ und $R^4$ gleich oder verschieden sein können und

$X^{\ominus}$ für ein nicht-nucleophiles Anion steht.

Weitere Gegenstände der Erfindung sind Verfahren zur Herstellung von Formkörpern oder Oberflächenbeschichtungen aus den genannten härtbaren Mischungen durch Erhitzen oder durch Bestrahlen mit Licht der Wellenlänge von 200 - 600 nm sowie lichtempfindliche Aufzeichnungsmaterialien enthaltend N-Sulfonylaminosulfoniumsalze zur Herstellung von Reliefbildern und Resistmustern.

Recht geeignete N-Sulfonylaminosulfonium-Salze der Formel (I) weisen als Reste $R^1$, $R^3$ und $R^4$

Methyl-, Ethyl-, n-Propyl-, i-Propyl-tert.-Butyl-, Cyclohexyl-, Cyclopentyl-, Stearyl-, Lauryl-, Methylphenyl-, Dimethylphenyl-, Trimethylphenyl-, Ethylphenyl-, Isopropylphenyl-, ein Chlor- oder Brom-, Dichlor- oder Dibromphenyl-, Methoxyphenyl-, Ethylthiophenyl-, ein Carboxyphenyl- oder ein Carbomethoxyphenylreste auf, als $R^2$ Methyl-, Ethyl-, Propyl-, Cyclohexyl-, Cyclopentyl-, Acetyl-, Propionyl-, Pivaloyl-, Benzoyl-, Methylbenzoyl-, Ethylbenzoyl- oder Chlorbenzoylreste.

Geeignete nicht-nucleophile Anionen $X^{\ominus}$ sind das Perchloration, das Trifluormethansulfonation sowie insbesondere Anionen der Formel (II)

$[MY_nZ_m]^{\ominus}$ (II),

wobei M für ein Bor-, Wismut-, Antimon-, Arsen- oder Phosphoratom, Y für Fluor und/oder Chlor und Z für eine Hydroxylgruppe steht und m für die Zahlen 0 oder 1, n für die Zahlen 4 - 6 steht mit der Maßgabe, daß die Summe aus m und n jeweils um eins höher ist als die Wertigkeit von M. $[MY_nZ_m]$ kann insbesondere sein ein Tetrafluoroborat-, Hexafluorophosphat-, Hexafluoroarsenat-, Hexachloroantimonat- oder Hexafluoroantimonat-Anion.

Sehr geeignete Härtungskatalysatoren der Formel (I) sind solche, bei denen $R^1$ einen Phenyl- oder $C_1$-$C_4$-Alkylphenylrest, $R^2$ einen $C_1$-$C_4$-Alkylrest, $R^3$ und $R^4$, gleich oder verschieden, einen $C_1$-$C_4$-Alkylrest, Phenylrest oder $C_1$-$C_4$-Alkyl-phenylrest darstellt und $X^{\ominus}$ eines der Anionen $BF_4^{\ominus}$, $PF_6^{\ominus}$, $AsF_6^{\ominus}$ oder $CF_3SO_3^{\ominus}$, insbesondere eines der ersten drei. Bevorzugt steht $R^1$ für einen Phenyl- oder p-Methylphenylrest, $R^2$ für eine Methyl- oder Ethylgruppe, $R^3$ und/oder $R^4$ für einen Methyl-, Ethyl-, Phenyl- oder p-Methylphenylrest. Beispiele sehr wirksamer N-Sulfonylaminoverbindungen sind die Salze des N-p-Toluolsulfonyl-methylaminodiphenylsulfonium-, des N-p Toluolsulfonyl-N-ethylaminodiphenylsulfonium-, des N-Phenylsulfonyl-N-methylaminodiphenylsulfonium-, des N-p-Toluolsulfonyl-N-methylaminodimethylsulfonium-, des N-p-Toluolsulfonyl-N-methylaminodiethylsulfonium- und des N-p-Toluolsulfonyl-N-methylamino-ditolylsulfonium-Kations mit dem Hexafluorophosphat-, Hexafluoroarsenat-, Hexafluoroantimonat-, Hexachloroantimonat-, Pentafluorohydroxyantimonat- oder Pentachlorohydroxyantimonat-Anion.

Geeignete Herstellverfahren für N-Sulfonylaminsulfoniumsalze sind zum Beispiel von P. Manya, A. Sekera und P. Rumpf in Bull. Soc. Chim. France 1971, Seite 286, von O. Bohman und S. Allenmark in Chem. Scripta 4, 202 (1973), von D. Darwish und S. K. Datta in Tetrahedron 30,1155 (1974) sowie von E. Vilsmaier, M. Huber und J. Schuetz in Liebigs Annalen der Chemie 1980, 1055 beschrieben.

Die erfindungsgemäßen härtbaren Harzzusammensetzungen enthalten

a) eine Verbindung bzw. ein Gemisch von Verbindungen, die unter dem Einfluß eines kationischen Katalysators in höhermolekulares Material überführbar sind und

b) bevorzugt 0,1 - 15 Gewichtsprozent der oben beschriebenen N-Sulfonylaminosulfoniumsalze, bezogen auf die Menge der Verbindungen a).

Die Verbindungen a) können beispielsweise Oxetane, Thiirane oder Tetrahydrofuran sein. Vorzugsweise ist Verbindung a) ein 1,2-Epoxid, eine olefinisch ungesättigte Verbindung, ein Aminoplast oder ein Phenoplast, soweit diese kationisch härtbar bzw. polymerisierbar sind.

Beispiele geeigneter 1,2-Epoxide sind Epichlorhydrin, Propylenoxyd oder Glycidylether eines einwertigen Alkohols oder Phenols, wie n-Butylglycidylether oder Phenylglycidylether, Glycidylester wie Glycidylacrylat oder Glycidylmethacrylat. Vorzugsweise ist Komponente a) ein Epoxidharz und insbesondere ein solches, das mindestens eine direkt an ein Sauerstoffatom gebundene Gruppe der Formel

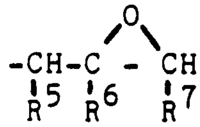

(III)

enthält, worin entweder $R^5$ und $R^7$ je ein Wasserstoffatom dastellen, in welchem Fall $R^6$ ein Wasserstoffatom oder eine Methylgruppe bedeutet, oder $R^5$ und $R^7$ zusammen $-CH_2CH_2-$ darstellen, in welchem Fall $R^6$ ein Wasserstoffatom bedeutet. Beispiele solcher Harze sind Polyglycidyl-und Poly($\beta$-methylglycidyl)-ester, die man durch Umsetzung einer zwei oder mehr Carbonsäuregruppen enthaltende Verbindung mit Epichlorhydrin, Glycerin-dichlorhydrin oder $\beta$-Methylepichlorhydrin in Gegenwart von Alkali erhalten kann. Solche Polyglycidylester können sich von aliphatischen Polycarbonsäuren, wie Bernsteinsäure, Glutarsäure, Adipinsäure, Pimelinsäure, Korksäure, Azelainsäure, Sebacinsäure oder dimerisierter oder trimerisierter Linolsäure, cycloaliphatischen Polycarbonsäuren wie Tetrahydrophtalsäure, 4-Methyltetrahydrophtalsäure,

Hexahydrophtalsäure und 4-Methylhexahydrophthalsäure und von aromatischen Polycarbonsäuren wie Phthalsäure, Isophthalsäure und Terephthalsäure ableiten. Weitere geeignete Polyglycidylester sind durch Polymerisation der Glycidylester von olefinisch ungesättigten Säuren, insbesondere von Glycidylacrylat und Glycidylmethacrylat, erhältlich.

Ferner geeignet sind Polyglycidyl- und Poly($\beta$-methylglycidyl)ether,wie sie durch Umsetzung einer mindestens zwei freie alkoholische und/oder phenolische Hydroxylgruppen pro Molekül enthaltenden Verbindung mit dem entsprechenden Epichlorhydrin unter alkalischen Bedingungen, oder auch in Gegenwart eines sauren Katalysators mit nachfolgender Alkalibehandlung erhältlich sind. Beispiele von Alkoholen und Phenolen für eine solche Umsetzung sind Ethylenglykol, Propandiol, Diethylenglykol, Poly(oxyethylen)-glykole, Poly(oxyporpylen)glykole, Poly(oxytetramethylen)glykole, Glycerin, 1,1,1-Trimethylolpropan, Pentaerythrit, Sorbit, Bis(4-hydroxy-cyclohexyl)-methan, 2,2-Bis(4-hydroxycyclohexyl)-propan, N,N-Bis(2-hydroxyethyl)anilin, p,p'-Bis(2-hydroxyethylamino)diphenylmethan, Bis(4-hydroxyphenyl)methan, Bis(4-hydroxyphenyl)sulfon, 2,2-Bis(4-hydroxyphenyl)propan, sowie Novolake, wie sie durch Umsetzung von Aldehyden wie Formaldehyd oder Acetaldehyd, mit Phenolen hergestellt werden können.

Beispiele für Epoxidharze mit Gruppen der Formel III, worin $R^5$ und $R^7$ zusammen eine $-CH_2CH_2-$Gruppe bedeuten, sind Bis-(2,3-epoxycyclopentyl)-ether oder 2,3-Epoxycyclopentylglycidylether.

Verwendbar sind auch Epoxidharze, in denen einige oder sämtliche Epoxidgruppen mittelständig sind, wie Vinylcyclohexendioxid, Dicyclopentadiendioxid, sowie epoxidierte Polybutadiene oder epoxidierte Copolymere des Butadiens mit Vinylmonomeren. Natürlich kann man auch Epoxidharzgemische verwenden.

Besonders bevorzugt verwendete Epoxidharze sind die Diglycidylether von zweiwertigen Phenolen und von zweiwertigen aliphatischen Alkoholen.

Gewünschtenfalls kann man das Epoxidharz auch in an sich bekannter Art einer Mischhärtung mit einem mehrwertigen Alkohol, insbesondere einem mit einem Molekulargewicht von über 1 000 unterwerfen. Geeignete Alkohole dafür sind beispielsweise Poly(oxyethylen)glykole, Polyvinylalkohole, Hydrooxypropylcellulose und Teilester der Cellulose.

Olefinisch ungesättigte Monomere a), die kationisch mit den N-Sulfonylaminosulfoniumsalzen polymerisiert werden können, sind z.B. Styrol, $\alpha$-Methylstyrol, Divinylbenzol, Vinylcyclohexan, 4-Vinylcyclohexan-1, N-Vinylcarbazol, Isopren, Butadien, sowie bevorzugt Vinylether wie Methylvinylether, Isobutylvinylether, 1,1,1-Trimethylolpropantrivinylether, Glycerintrivinylether, die Vinylether von Ethylenglykol und Polyethylenglykolen sowie cyclische Vinylether.

Die als Komponente a) bevorzugten Aminoplaste enthalten pro Molekül mindestens zwei an ein Amid- oder Thioamidstickstoffatom bzw. -atome gebundene Methylolgruppen, die auch verethert oder verestert sein können. Beispiele solcher Aminoplaste sind die N-Hydroxymethyl-, N-Methoxymethyl-, N-Butoxymethyl- und N-Acetoxymethylderivate von Harnstoff, Thioharnstoff oder cyclischen Harnstoffen, von Carbamaten und Dicarbamaten aliphatischer einwertiger und zweiwertiger Alkohole, sowie von Melamin, wie teilverethertes Hexamethylolmelamin oder von weiteren Polyamino-1,3-triazinen. Bevorzugte Aminoplaste sind die Kondensationsprodukte des Harnstoffs, Hydantoins oder Melamins mit Formaldehyd,z.B.ein Kondensationsprodukt aus Harnstoff mit 1,8 Mol Formaldehyd, sowie teilweise oder völlig veretherte Produkte solcher Kondensationsprodukte mit einem aliphatischen einwertigen Alkohol mit 1 bis 4 Kohlenstoffatomen, wie Hexamethoxymethylmelamin.

Als Phenoplaste werden die bekannten aus einem ein-oder mehrwertigen Phenol und einem Aldehyd wie Formaldehyd hergestellten Resole bevorzugt. Den erfindungsgemäßen härtbaren Mischungen können gegebenenfalls geeignete Zusätze wie Verdünnungsmittel, Verstärkungsmittel, Füllstoffe, Farbstoffe, Pigmente, Verarbeitungshilfsmittel oder andere übliche Zusatzstoffe zugegeben werden, deren Art und Menge dem Fachmann bekannt sind.

Die mit Hilfe der beschriebenen N-Sulfonylaminosulfoniumsalze hergestellten härtbaren Harzzusammensetzungen können zur Beschleunigung der Härtung ferner als zusätzliche Komponente ein Oxidationsmittel aus der Klasse der Chinone und der organischen Peroxide enthalten. Geeignete Verbindungen sind beispielsweise Keton-Peroxide, Peroxysäuren, Aldehyd-Peroxide, Hydroperoxide, vor allem jedoch Alkylperoxide, Diacylperoxide und Alkylester von Persäuren wie z.B. Butylperoxypivalat, Benzoylperoxide, Di-tert.-butylperoxid, tert.-Butyl-hydroperoxid, Methylethylketon-Peroxid, m-Chlorperbenzoesäure. Beispiele für geeignete Chinone sind die ganz oder teilweise durch Chlor-oder Cyan-Gruppen substituierten Benzochinone wie Chloranil oder 2,3-Dichlor-5,6-Dicyanbenzochinon.

Die erfindungsgemäßen härtbaren Mischungen enthalten im allgemeinen 0,1 bis 15, vorzugsweise 0,5 bis 10 Gewichtsprozent der N-Sulfonylaminosulfoniumsalze sowie gegebenenfalls 0,01 - 10, vorzugsweise 0,05 - 2 Gewichtsprozent der vorstehend genannten Oxidationsmittel, stets bezogen auf die Gesamtmenge der härtbaren Verbindungen a).

Die erfindungsgemäßen Mischungen können durch Erhitzen oder durch Bestrahlung mit aktinischem

Licht der Wellenlänge 200 - 600 nm gehärtet werden, wobei das optimale Härtungsverfahren von den eingesetzten Kömponenten der Mischungen sowie vom Verwendungszweck derselben abhängt.

Vorzugsweise enthalten die erfindungsgemäßen Zusammensetzungen auch einen Sensibilisator. Es wurde gefunden, daß die Einarbeitung geeigneter Sensibilisatoren die Härtungsgeschwindigkeit noch weiter steigert, was die Anwendung noch kürzerer Belichtungszeiten und/oder weniger starker Bestrahlungsquellen ermöglicht. Außerdem wird die Empfindlichkeit für sichtbares Licht erhöht. Geeignete Sensibilisatoren sind Acetophenonderivate wie Benzildimethylketal oder Benzoinether, Benzophenon oder dessen Derivate sowie Thioxanthon-Derivate wie 2-Methyl- oder 2-Isopropylthioxanthon. Weiter geeignete Sensibilisatoren sind polycyclische Aromaten, wie Anthracen, Phenanthren, Rubren, Perylen und Pyren. Vorzugsweise arbeitet man mit 0,1 - 2 Gew.% an Sensibilisatoren, bezogen auf dei Gesamtmenge an Komponenten a).

Als aktinische Strahlungsquellen für die Photohärtung bei 200 - 600 nm Wellenlänge eignen sich die bekannten wie Kohlebogenlampen, Quecksilberdampflampen, ultraviolettes Licht ausstrahlende Leuchtröhren, Argon- und Xenonglimmlampen und photographische Flutlampen. Die zur Belichtung erforderliche Zeit hängt unter anderem vom verwendeten polymerisierbaren Material, der Art der Lichtquelle und deren Abstand vom bestrahlten Material ab und ist vom Fachmann in einem Vortest leicht bestimmbar.

Soll die härtbare Zusammensetzung thermisch gehärtet werden, so wird sie in eine geeignete Form gebracht, z.B. als dünner Film ausgegossen. Zur Härtung wird das Harz auf Temperaturen zwischen 80 und 160 °C, vorzugsweise zwischen 100 und 150 °C erhitzt.

Die erfindungsgemäßen Zusammensetzungen sind z.B. als Oberflächenbeschichtungen verwendbar und nach Aufbringen auf ein Substrat wie Stahl, Aluminium, Kupfer, Cadmium, Zink, Papier oder Holz durch Bestrahlen oder Erhitzen aushärtbar. Bestrahlt man durch eine Maske, so kann man dann die unbelichteten Schichtanteile durch Auswaschen entfernen. Die erfindungsgemäßen Mischungen sind besonders für die Herstellung von Druckplatten und gedruckten Schaltungen verwendbar, wobei die bekannten Methoden zur Herstellung von Druckplatten und gedruckten Schaltungen aus photopolymerisierbaren Zusammensetzungen angewandt werden können.

Die erfindungsgemäßen Mischungen sind auch als Klebstoffe, bei der Herstellung von faserverstärkten Verbundstoffen, einschließlich Plattenpreßmassen, zur Herstellung von Kitten und Spachtelmassen oder für Tauchbeschichtungen verwendbar.

Eine erfindungsgemäße Mischung mit z.B. einem Epoxidharz oder Phenoplast und einer zur Polymerisation dieses Epoxidharzes oder Phenoplastes bei Belichtung der Zusammensetzung mit aktinischer Srahlung wirksamen Menge eines N-Sulfonylaminosulfoniumsalzes kann auch eine härtende Menge eines latenten Heißhärters für das Epoxidharz oder Phenoplast enthalten, wie Polycarbonsäureanhydride, Komplexe von Aminen, insbesondere primären oder tertiären aliphatischen Aminen mit Bortrifluorid oder Bortrichlorid und latente Bortrifluoridchelate. Geeignete hitzeaktivierbare Vernetzungsmittel für Resole sind unter anderem Hexamethylentetramin und Paraformaldehyd. Die für die Heißhärtung erforderliche Temperatur und Erhitzungsdauer sowie die Anteile an hitzeaktivierbarem Härter lassen sich leicht durch Vorversuche in bekannter Weise ermitteln.

Eine besondere Anwendungsform der erfindungsgemäßen Mischungen mit den N-Sulfonylaminosulfoniumsalzen ist als lichtempfindliches Aufzeichnungsmaterial für die Herstellung von Reliefbildern oder Resistmustern mit einer auf einem dimensionsstabilen Träger aufgebrachten lichtempfindlichen härtbaren Schicht.

In der DE-A 33 26 036 ist ein photoempfindliches Aufzeichnungsmaterial mit einer auf einem dimensionsstabilen Träger aufgebrachten festen, lichtempfindlichen, härtbaren Schicht (S) beschrieben, die

(i) mindestens eine Verbindung mit zwei aromatischen und/oder heteroaromatischen o-Nitrocarbinolestergruppierungen der allgemeinen Formel (VI)

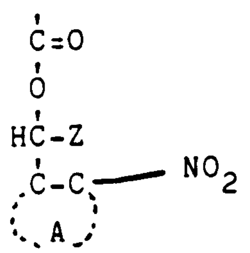

(VI),

worin A den Rest eines aromatischen oder heteroaromatischen, gegebenenfalls substituierten Ringsystems mit 5 bis 14 Ringgliedern und Z ein Wasserstoffatom, einen Alkylrest mit 1 bis 8 Kohlenstoffatomen oder einen gegebenenfalls substituierten Aryl- oder Aralkylrest bedeuten,

(ii) mindestens eine vernetzend wirkende Verbindung mit mindestens zwei reaktiven Gruppen, die unter dem Einfluß von Wärme mit -COOH-Gruppen unter Bildung einer kovalenten chemischen Bindung zu reagieren vermögen, wobei (ii) auch als Gruppierung(en), z.B. Amin- Imin-, Amid-, Epoxid-oder Hydroxy-Gruppierungen in den Verbindungen (i) enthalten sein können, und

(iii) mindestens einen Katalysator für die Reaktion der vernetzend wirkenden Verbindung (ii) mit -COOH-Gruppen enthaltenden Verbindungen enthält, der in verkappter, nicht aktiver Form vorliegt, aber photochemisch und/oder thermisch aktivierbar ist.

Es hat sich gezeigt, daß sich die in den erfindungsgemäßen Mischungen verwendeten N-Sulfonylaminosulfoniumsalze hervorragend als thermisch aktivierbare Katalysatoren für die Reaktion der vernetzend wirkenden Verbindungen (ii) mit den COOH-Gruppen eignen. Bezüglich weiterer Aufgaben zu dieser Verwendung der erfindungsgemäßen Mischungen für solche Aufzeichnungsmaterialien sei auf die DE-A 33 26 036, DE-A 32 31 147 und DE-A 32 31 145 verwiesen. Der Einsatz von N-Sulfonylaminosulfoniumsalzen der Formel (I) verleiht solchen Aufzeichnungsmassen eine gute Lagerstabilität bei geringer Nachhärtungszeit. So können sie beispielsweise mehrere Wochen bei 50 °C gelagert werden, ohne daß sich dadurch die sehr guten Eigenschaften der Aufzeichnungsmaterialien und die hohe Qualität der hieraus hergestellten Reliefbilder oder Resistmuster verschlechtern.

Erfindungsgemäße lichtempfindliche Aufzeichnungsmaterialien eignen sich für die Herstellung von Hoch-, Tief-, Offset- oder Siebdruckformen, Photoresisten und Lötstoppmasken. Sie eignen sich auch für Schichtübertragungsmaterialien bei der Herstellung von Leiterplatten, gedruckten Schaltungen, integrierten Schaltungen etc. Die Herstellung der Reliefbilder oder Resistmuster mittels der erfindungsgemäßen N-Sulfonylaminosulfoniumsalze enthaltenden Aufzeichnungsmaterialien kann wahlweise nach negativ arbeitenden oder positiv arbeitenden Verfahren erfolgen, wie sie an sich bekannt und beispielsweise in der DE-A 23 09 062 sowie den DE-A 32 31 144, DE-A 32 31 145 und DE-A 32 31 147 beschrieben sind.

Hierzu wird zunächst die lichtempfindliche härtbare Schicht (S) der erfindungsgemäßen Aufzeichnungsmaterialien bildmäßig mit aktinischem Licht im Wellenbereich von 200 bis 600 nm, vorzugsweise von 300 bis 420 nm, belichtet, z.B. mit Kohlebogenlampen oder Quecksilberniederdruckfluoreszenzlampen. Die bildmäßige Belichtung erfolgt dabei je nach Verfahrensführung entweder durch ein Bildpositiv oder Bildnegativ oder bei der Herstellung von Tiefdruckformen auch durch ein Raster oder Rasterpositiv bzw. ein Raster oder Rasternegativ, wobei letzteres auch zusammen mit einem Halbtonnegativ angewandt werden kann. Die bildmäßige Belichtung der lichtempfindlichen härtbaren Schicht (S) kann auch mit einem bildmäßig modulierten aktinischem Laserstrahl z.B. einem UV-Laser, erfolgen. Die Belichtungszeiten für die bildmäßige Belichtung liegen im allgemeinen im Bereich von 0,05 bis 50 Minuten.

Bei den positiv arbeitenden Verfahren zur Herstellung der Reliefbilder oder Resistmuster werden nach der bildmäßigen Belichtung der lichtempfindlichen härtbaren Schicht (S) die belichteten Schichtanteile, in denen die photoempfindlichen Substanzen wie die o-Nitrocarbinolestergruppierungen unter Bildung von freien Carboxylgruppen gespalten worden sind, mit einem wäßrigen Entwicklerlösungsmittel in üblicher Weise, beispielsweise durch Besprühen, Ausreiben oder Ausbürsten, entfernt. Der Vorgang der bildmäßigen Belichtung und des Auswaschens der lichtempfindlichen Schicht (S) kann bei den positiv arbeitenden Verfahren auch mehrmals wiederholt werden. Nach der letzten Belichtung sowie dem Entfernen der belichteten Schichtanteile wird der auf dem Träger verbliebene Teil der lichtempfindlichen Schicht (S), der nunmehr bereits ein positives Abbild der bildmäßigen Vorlage darstellt, vollflächig mit aktinischem Licht nachbelichtet. Für diese vollflächige Nachbelichtung können die gleichen Lichtquellen herangezogen werden, wie für die vorerwähnte bildmäßige Belichtung, wobei die Dauer für die vollflächige Nachbelichtung im allgemeinen im Bereich von 0,05 bis 50 Minuten liegt. Im Anschluß an die vollflächige Nachbelichtung wird die Schicht (S) thermisch vernetzt und gehärtet.

In negativ arbeitenden Verfahren werden nach der bildmäßigen Belichtung der Schicht (S) die belichteten Bereiche zunächst selektiv thermisch gehärtet und vernetzt. Die nichtvernetzten Bereiche der Schicht (S) können danach direkt mit einem geeigneten Entwicklerlösungsmittel ausgewaschen werden. Vorteilhafterweise wird jedoch die Schicht (S) zunächst noch einmal vollflächig mit aktinischem Licht nachbelichtet und dann mit einem wäßrigen Entwicklerlösungsmittel ausgewaschen. Nach dem Auswaschen der Schicht (S) kann diese noch einmal thermisch nachgehärtet und nachvernetzt werden. Erfolgt das Auswaschen der Schicht (S) unmittelbar nach der bildmäßigen Belichtung, so ist für eine solche thermische Nachvernetzung und Nachhärtung die Schicht (S) nach dem Auswaschen noch einmal vollflächig mit aktinischem Licht zu belichten.

Als Entwicklungsmittel können geeignete Lösungsmittel verwendet werden; vorzugsweise sowohl in den positiv arbeitenden als auch den negativ arbeitenden Verfahren wäßrige Entwickler-Lösungsmittel. Hierbei kann es sich um Wasser oder auch um Mischungen von Wasser mit wasserlöslichen organischen Lösungsmitteln handeln, denen gegebenenfalls zur Einstellung eines optimalen pH-Wertes geringe Mengen

an Alkalien oder organischen Basen zugesetzt werden können.

Die Bedingungen für die thermische Härtung und Vernetzung der Schicht (S) hängen von der als Katalysator verwendeten N-Sulfonylaminosulfoniumverbindung ab. Vorteilhaft wird die Härtung und Vernetzung bei erhöhten Temperaturen durchgeführt. Im allgemeinen können mit den erfindungsgemäßen Aufzeichnungsmaterialien die Temperaturen für die thermische Härtung und Vernetzung der Schicht (S) unter 150 °C gehalten werden, so daß auch thermisch empfindliche Untergründe, wie sie z.B. in der Dünnschichttechnologie und bei der Herstellung von Leiterbahnen zur Anwendung kommen können, als Trägermaterialien eingesetzt werden können. Im allgemeinen liegen die Temperaturen für die thermische Härtung und Vernetzung der Schicht (S) im Bereich von 30 bis 150 °C, vorzugsweise im Bereich von 50 bis 130 °C. Die Dauer für die thermische Härtung und Vernetzung der Schicht (S) liegt üblicherweise im Bereich von 10 Minuten bis einigen Stunden, beispielsweise 5 Stunden. Dabei werden die Bedingungen für die thermische Härtung der Schicht (S) so gewählt, daß die gehärteten und vernetzten Reliefbilder oder Resistmuster die gewünschten mechanischen, physikalischen und chemischen Eigenschaften besitzen.

Die Erfindung wird durch die nachfolgenden Versuche und Beispiele näher erläutert. Die in den Beispielen genannten Teile und Prozente beziehen sich, sofern nicht anders angegeben, auf das Gewicht. Volumenteile verhalten sich zu Teilen wie Liter zu Kilogramm.

Herstellungsbeispiele 1 bis 3

1. Herstellung von N-p-Toluolsulfonyl-N-methylaminodiphenylsulfoniumtrifluormethansulfonat (I)

10,65 g (0,03 Mol) N-p-Toluolsulfonyl-diphenylsulfilimin wurden in 50 ml trockenen Toluol suspendiert und nach Zusatz von 6,55 g (0,04 Mol) Trifluormethansulfonsäuremethylester 2 Stdn. unter Rückfluß gerührt. Beim Abkühlen trennt sich die Reaktionslösung in zwei Phasen, von denen die Unterphase abgetrennt wurde. Der beim Einengen der Unterphase verbleibende feste Rückstand wurde aus Essigester umkristallisiert und getrocknet. Es wurden 11,0 g des Salzes (I) erhalten. Analyse und Eigenschaften sind in Tab. 1 angegeben.

2.u.3.: In analoger Weise wie vorstehend angegeben wurden die in Tabelle 1 mit Analysen und Eigenschaften angeführten Verbindungen II und III hergestellt.

Herstellungsbeispiele 4 bis 6

4. Herstellung von N-p-Toluolsulfonyl-N-methylaminodiphenylsulfoniumtetrafluoroborat (IV)

10,65 g (0,03 Mol) N-p-Toluolsulfonyldiphenylsulfilimin wurden in 40 ml trockenem Methylenchorid gelöst und 4,44 g (0,03 Mol) Trimethyloxoniumtetrafluoroborat zugegeben. Nach Rühren über Nacht und Einengen fiel das Reaktionsprodukt kristallin aus. Nach Trocknen im Vakuum wurden 11,45 g des Salzes (IV) erhalten. Analyse und Eigenschaften sind in Tab. 1 angegeben.

5.u.6.: In analoger Weise wie vorstehend angegeben wurden die in Tabelle 1 mit Analysen und Eigenschaften angeführten Verbindungen V und VI hergestellt.

Beispiele 7 bis 9

7. Herstellung von N-p-Toluolsulfonyl-N-methylaminodiphenylsulfoniumhexafluorophosphat (VII)

65,8 g (0,185 Mol) p-Toluolsulfonyldiphenylsulfilimin und 46,6 g (0,37 Mol) Dimethylsulfat wurden in 750 ml Toluol 14 Std. unter Rückfluß erhitzt. Die Unterphase des erhaltenen zweiphasigen Reaktionsgemisches wurde abgetrennt und in eine Lösung von 216,5 g (1,1 Mol) 75 %iger Hexafluorophosphorsäure, 185 ml Wasser und 37 ml Ethanol eingerührt. Das dabei auskristallisierte Rohprodukt wurde abgesaugt. Nach Umkristallisieren aus Aceton/Wasser und Trocknen im Vakuum wurden 61,6 g des Salzes VII erhalten.

8.u.9.: In analoger Weise wie vorstehend angegeben wurden die in Tab. 1 mit Analysen und Eigenschaften angeführten Verbindungen VIII und IX hergestellt.

**Tabelle 1**

N-Sulfonylaminosulfoniumsalze der Formel

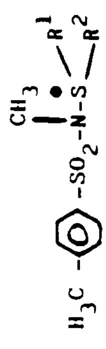

$X^{\ominus}$

| Herst.beispiel/ Verbindung | $R^1$ | $R^2$ | $X^{\ominus}$ | Schmp.(°C) | Analysen | | | | | |
|---|---|---|---|---|---|---|---|---|---|---|
| 1/ 1 | Ph | Ph | $CF_3SO_3^{\ominus}$ | 126-7 | ber. C 48,55<br>gef. C 48,3 | H 3,85<br>H 3,8 | S 18,5<br>S 18,9 | N 2,70<br>N 2,7 | | F 10,98<br>F 10,8 |
| 2/II | Ph | $CH_3$ | $CF_3SO_3^{\ominus}$ | 89-94 | ber. C 42,01<br>gef. C 41,7 | H 3,94<br>H 4,0 | S 21,01<br>S 20,7 | N 3,06<br>N 3,2 | | F 12,47<br>F 12,3 |
| 3/III | $CH_3$ | $CH_3$ | $CF_3SO_3^{\ominus}$ | 139-41 | ber. C 33,42<br>gef. C 33,1 | H 4,05<br>H 4,0 | S 24,30<br>S 24,3 | N 3,54<br>N 3,6 | | F 14,43<br>F 14,1 |
| 4/IV | Ph | Ph | $BF_4^{\ominus}$ | 176-8 | ber. C 52,52<br>gef. C 52,7 | H 4,38<br>H 4,5 | S 14,0<br>S 14,3 | N 3,06<br>N 3,1 | B 2,41<br>B 2,4 | F 16,63<br>F 16,5 |
| 5/V | Ph | $CH_3$ | $BF_4^{\ominus}$ | 101-104 | ber. C 45,57<br>gef. C 45,6 | H 4,56<br>H 4,5 | S 16,2<br>S 16,5 | N 3,54<br>N 3,6 | B 2,78<br>B 4,1 | F 19,24<br>F 18,7 |
| 6/VI | $CH_3$ | $CH_3$ | $BF_4^{\ominus}$ | 178-181 | ber. C 36,04<br>gef. C 36,1 | H 4,81<br>H 4,8 | S 19,22<br>S 19,4 | N 4,2<br>N 4,2 | B 3,3<br>B 3,3 | F 22,82<br>F 22,7 |
| 7/VII | Ph | Ph | $PF_6^{\ominus}$ | 182-88 | ber. C 46,6<br>gef. C 47,8 | H 3,88<br>H 4,0 | S 12,46<br>S 13,0 | N 2,72<br>N 2,8 | P 6,02<br>P 5,8 | F 23,3<br>F 22,8 |
| 8/VIII | Ph | Ph | $AsF_6^{\ominus}$ | 190-91 | ber. C 42,93<br>gef. C 43,3 | H 3,58<br>H 3,5 | S 11,45<br>S 11,7 | N 2,50<br>N 2,6 | As 13,42<br>As 13,5 | F 20,39<br>F 20,3 |
| 9/IX | Ph | Ph | $SbF_6^{\ominus}$ | 169-73 | ber. C 39,64<br>gef. C 40,3 | H 3,30<br>H 3,3 | S 10,57<br>S 10,5 | N 2,31<br>N 2,4 | Sb 20,07<br>Sb 19,7 | F 18,83<br>F 18,1 |

Ph = Pheryl

## Beispiele 1 bis 7

Härtung von Epoxidharzen mit N-Sulfonylaminosulfoniumsalzen

Harzmischungen aus Bisphenol-A-diglycidylether (Epikote® 828 der Fa. Shell) und den in Tabelle 2 angegebenen Katalysatoren(vgl. hierzu Tab. 1) wurden durch Mahlen in einer Achat-Mühle bei Raumtemperatur hergestellt. Die verschiedenen Mischungen von jeweils gleicher Menge wurden in Reagenzgläser

gefüllt und jeweils in ein vorgeheiztes Ölbad getaucht. In alle Proben tauchte ein Thermoelement ein, wodurch der Verlauf der exothermen Härtungsreaktion verfolgt werden konnte. War 10 Min. nach Angleichung der Probentemperatur an die Badtemperatur noch kein Effekt festzustellen, wurde die Badtemperatur um 20 °C erhöht usw. Der Verlauf der Härtungsreaktion wurde als Temperatur-Zeit-Kurve aufgezeichnet und durch folgende Daten charakterisiert:

a. Ansprechtemperatur: Badtemperatur

b. Härtungszeit: Zeit von Angleichen der Probentemperatur an die Badtemperatur bis zur Maximaltemperatur

c. Maximaltemperatur

Tabelle 2

| Härtung von Epikote® 828 mit N-Sulfonylaminosulfoniumsalzen als Katalysator | | | | |
|---|---|---|---|---|
| Katalysatorverbindung | Konz. in Epikote®828 (phr ) | Ansprechtemp.(°C) | Härtungszeit (min.sec.) | Maximaltemp.(°C) |
| VII | 2,4 | 140 | 6'05" | 229 |
| VII | 3,0 | | | |
| VIII | 2,4 | 140 | 7'50" | 173 |
| IV | 2,4 | 160 | 2'25" | 195 |
| I | 2,4 | 140 | 28' | 250 |
| III | 1,0 | 160 | 4'40" | 253 |
| II | 1,0 | 140 | 10' | 247 |
| phr = Teile je hundert Teile Harz | | | | |

Beispiele 8 bis 10

Einfluß von Co-Katalysatoren auf das Härtungsverhalten von Epoxidharzen mit N-Sulfonylaminosulfoniumsalzen

Es wurden in der in den Beispielen 1 bis 7 beschriebenen Weise Harzmischungen aus 100 Teilen Bisphenol-A-diglycidylether (Epikote® 828 der Fa. Shell), 2,4 Teilen der Verbindung VII und den in Tabelle 3 angegebenen Co-Katalysatoren hergestellt und der Verlauf der Vernetzungsreaktion über die Temperatur-Zeit-Kurve in der in den Beispielen 1 bis 7 beschriebenen Weise charakterisiert. Die in Tab. 3 angegebenen Ergebnisse zeigen, daß Peroxide und Chinone die Härtungsaktivität von N-Sulfonylaminosulfoniumsalzen deutlich steigern.

Tabelle 3

Einfluß von Co-Katalysatoren auf das Härtungsverhalten von Epikote® 828 mit dem N-Sulfonylaminosulfoniumsalz VII (vgl. Tab. 1) (Einsatzkonzentration 2,4 %)

| Co-Katalysator | | | | Härtungsaktivität | |
|---|---|---|---|---|---|
| Beispiel | Typ | Konz.(%) | Ansprechtemp. (°C) | Härtungszeit (min/sec) | Maximal temperatur (°C) |
| 8 | ohne | - | 140 | 6' 05" | 229 |
| 9 | t-Butylperbenzoat | 2 | 140 | 3' 50" | 225 |
| 10 | 2,3-Dichlor-5,6-dicyan-p-benzochinon | 0,5 | 140 | 2'53" | 254 |

Beispiele 11 und 12

Lagerstabilität von Epoxidharzen mit N-Sulfonylaminosulfoniumsalzen

In der in den Beispielen 1 bis 7 beschriebenen Weise wurden Mischungen von 100 Teilen Bisphenol-A-diglycidylether und 2,4 bzw. 3,0 Teilen von N-p-Toluolsulfonyl-N-methylamino-diphenylsulfonium-hexafluorophosphat hergestellt und die Viskosität in Funktion von der Lagerzeit bei Raumtemperatur (25 °C) verfolgt. Die Ergebnisse sind in Tab. 4 zusammengestellt. 5-monatige Lagerung bei 20 °C erhöht die Viskosität der Mischungen um weniger als das 7fache. Eine so gelagerte Mischung ist noch gut verarbeitbar.

Tabelle 4

| Lagerstabilität von Epoxidharzen mit N-p-Toluolsulfonyl-N-methylamino-diphenyl-Sulfoniumhexafluorophosphat des Katalysator | | |
|---|---|---|
| Lagerzeit bei 25 °C (Tage) | Katalysatorkonzentration 2,4 % Viskosität (m Pas) bei 20 °C | Katalysatorkonzentration 3,0 % Viskosität (m Pas) bei 20 °C |
| 0 | 26 000 | 27 400 |
| 33 | - | 38 800 |
| 36 | 33 400 | - |
| 62 | - | 53 700 |
| 65 | 55 500 | - |
| 136 | - | 172 000 |
| 150 | 169 000 | - |

Beispiele 13 und 14

Eigenschaften ausgehärteter Formstoffe

Beispiel 13

In der in den Beispielen 1 bis 7 beschriebenen Weise wurde eine Mischung M 1 aus 100 Teilen Bisphenol-A-diglycidylether, 3 Teilen N-p-Toluolsulfonyl-N-methylamino-diphenyl-sulfonium-hexafluorophosphat und 0,5 Chloranil hergestellt und 15 Min. bei 140 °C gehärtet sowie 75 Min. bei 200 °C nachgehärtet. Die nach DIN 53 445 bestimmte Glastemperatur betrug 145 °C.

Beispiel 14

In gleicher Weise wie in Beispiel 13 wurde aus 100 Teilen Bisphenol-A-diglycidylether und 2,4 Teilen N-p-Toluol-N-methylamino-diphenyl-sulfonium-hexafluorophosphat eine Mischung M2 hergestellt. Nach 30minütiger Härtung bei 150 °C und 1⁻stündiger Nachhärtung bei 200 °C wurde eine Glastemperatur von 130 °C bestimmt.

Beispiele 15 und 16

Lichtempfindliche Aufzeichnungsmeterialien

Je 72 Teile eines Methylmethacrylat-Copolymerisats, welches 35 % o-Nitrobenzylacrylat einpolymerisiert enthielt, 27 Teile eines Bisphenol-A-diglycidylethers (Epikote® 828 der Firma Shell), 0,7 Teile Benzildimethylketal, 0,1 Teile eines schwarzen Farbstoffes, 0,2 Teile des Polymethinfarbstoffes der Formel

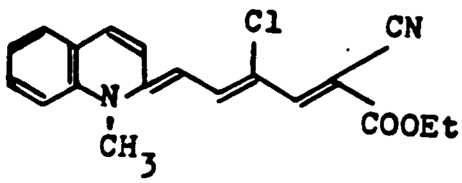

sowie 4 Teile der Salze VII (Beispiel 15) bzw. VIII (Beispiel 16) gemäß Tabelle 1 als Katalysatoren wurden in je 160 Volumenteilen Essigsäureethylester gelöst. Aus diesen Lösungen wurden auf Polyesterfolien lichtempfindliche härtbare Schichten (S) so aufgegossen, daß nach Entfernung des Lösungsmittels und Trocknung Schichtdicken von jeweils etwa 10 µm resultieren.

Danach wurden zur Herstellung von Resistmustern die freien Oberflächen der Schichten (S) je 90 sec vollflächig mit einer 500 Watt Höchstdruck-Quecksilberlampe vorbelichtet und auf ein mit Palladium bedampftes Glas auflaminiert. Die lichtempfindlichen Schichten (S) wurden dann mittels einer photographischen Positiv-Vorlage durch die Polyesterfolie hindurch jeweils mit einer 500 W-Höchstdruck-Quecksilberlampe 2 Minuten lang bildmäßig belichtet. Anschließend wurden die Polyesterfolien von den Schichten (S) abgezogen und die belichteten Anteile der Schichten (S) mit einem wäßrigen Entwicklerlösungsmittel (81 Teile Wasser, 16 Teile 2-Butoxyethanol, 3 Teile Triethanolamin) in 1,5 Minuten ausgewaschen. Die so erhaltenen vorlagentreuen Resistmuster wurden mit der gleichen Lampe wie oben nochmals vollflächig, d.h. ohne bildmäßige Vorlage, für eine Dauer von jeweils 15 Minuten nachbelichtet und dann jeweils insgesamt 120 Minuten in steigenden Temperaturschritten von je 20 °C im Temperaturbereich von 60 °C bis 140 °C thermisch gehärtet und vernetzt. Die erhaltenen Resiste waren hervorragend als Ätzresiste geeignet und gegen die konzentrierte Salpetersäure (65 %ig) des Palladiumätzbades stabil. Nach dem Ätzen und Strippen der Resiste mit heißem Dimethylformamid wurden so Palladiumbahnen erhalten, die eine getreue Wiedergabe der Bildvorlage darstellten.

Beispiele 17 und 18 sowie Vergleichsversuche 1 und 2

Oberflächenbeschichtungen

Jeweils 15 %igen acetonischen Lösungen von Bisphenol-A-diglycidylether wurden die nachstehenden Salze als Katalysatoren in Mengen zugesetzt, daß der Katalysatoranteil jeweils 3 %, bezogen auf den Bisphenol-A-diglycidylether betrug.

| | |
|---|---|
| Beispiel 17: | N-p-Toluolsulfonyl-N-methylamino-diphenylsulfonium-hexafluoroarsenat (Verbindung VIII gemäß Tab. 1) |
| Beispiel 18: | N-p-Toluolsulfoyl-N-methylamino-diphenylsulfonium-hexafluoroantimonat (Verbindung IX gemäß Tab. 1) |
| Vergleichsversuch 1: | N-Phenylcarbamoylmethylsulfoxoniumhexafluorophosphat (vgl. EP-A 44 274). |
| Vergleichsversuch 2: | Bis(p-Tolyl)iodonium-hexafluoroarsenat (vgl. DE-A 25 18 639). |

Die ohne Erwärmung hergestellten photoempfindlichen Mischungen wurden mit einem 80 µm-Rakel (effektive Schicht dicke ca. 50 µm) auf Glasplatten aufgezogen, vor der Belichtung 5 Min. zur Entfernung des Acetons abgelüftet und unter Luft im Abstand von ca. 10 cm mit den jeweils angegebenen Bandgeschwindigkeiten an 2 Lampen mit 80 W/cm Leistung vorbeiführt. Die Beurteilung der belichteten Schichten erfolgte sofort nach der Belichtung, nach 2 Stdn. und nach 1 Tag nach folgenden Qualitätsmerkmalen:

| | |
|---|---|
| geliert: | nicht mehr fließfähig, klebrig |
| fest: | Oberfläche klebfrei, jedoch nicht fingernagelhart |
| durchgehärtet: | klebfrei, fingernagelhart. |

Wie die in Tab. 5 angegebenen Ergebnisse zeigen, sind die Mischungen gemäß Beispielen 17 und 18 deutlich besser als die Mischung gemäß Vergleichsversuch 1 und etwa ebensogut wie die Mischung gemäß Vergleichsversuch 2, die jedoch ein toxisches Katalysatorsalz enthält.

Tabelle 5 Härtung der Oberflächenbeschichtung

| Härtung | Härtungsergebnis Bandgeschwindigkeit 3 m/Min. | | |
|---|---|---|---|
| | sofort | nach 2 Stdn. | nach 1 Tag |
| Vgl.versuch 1 | geliert | geliert | geliert |
| Vgl.versuch 2 | durchgehärtet | durchgehärtet | durchgehärtet |
| Beispiel 17 | fest | durchgehärtet | durchgehärtet |
| Beispiel 18 | fest | durchgehärtet | durchgehärtet |

| Härtung | Härtungsergebnis Bandgeschwindigkeit 15 m/Min. | | |
|---|---|---|---|
| | sofort | nach 2 Stdn. | nach 1 Tag |
| Vgl.versuch 1 | geliert | geliert | geliert |
| Vgl.versuch 2 | fest | fest | durchgehärtet |
| Beispiel 17 | geliert | fest | fest |
| Beispiel 18 | fest | fest | durchgehärtet |

Beispiele 19 - 21

Es wurde in der in den Beispielen 17 und 18 beschriebenen Weise 1 % des Salzes VIII gemäß Tabelle 1 als Katalysator in Epicote® 828 gelöst und die angegebene Menge der in Tab. 6 beschriebenen Verbindungen, bezogen auf Epicote® 828, zugesetzt. Anschließend wurde in der in den Beispielen 17 und 18 beschriebenen Weise abgelüftet und bei einer Bandgeschwindigkeit von 15 m gehärtet. Nach eintägiger Lagerung wurde die Pendelhärte der erhaltenen Lackfilme nach König bestimmt.

Die Ergebnisse in Tab. 6 zeigen, daß die mit N-Sulfonylaminosulfoniumsalzen erzielbare Härtungsgeschwindigkeit durch Zusätze anderer Initiatoren, die allein die Härtung von Epoxiden nicht auslösen, deutlich beschleunigt wird.

Tabelle 6

| Beschleunigung der Härtung mit N-Sulfonylaminosulfoniumsalzen durch andere Initiatoren | | | |
|---|---|---|---|
| Zusatz | Bsp. 19<br>kein Zusatz | Bsp. 20<br>Benzildimethylketal 2 % | Bsp. 21<br>2-Methylthioxanthon 1 % |
| Härte nach König nach 1 Tag (sec) (bei Härtungsgeschwindigkeit von 15 m/Min) | 109 | 211 | 160 |

**Patentansprüche**

1. Härtbare Mischungen, enthaltend
   a) mindestens eine Verbindung, die unter dem Einfluß eines kationischen Katalysators in eine höhermolekulare Verbindung überführbar ist, und
   b) einen Härtungskatalysator der Formel (I)

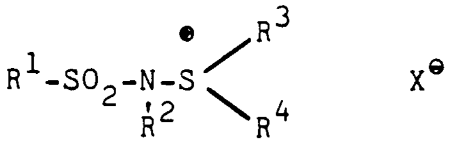

(I),

   worin $R^1$ ein $C_1$ - $C_{18}$-Alkylrest, ein 5- oder 6-Ring- Cycloalkylrest oder ein gegebenenfalls durch Chlor- oder Bromatome, $C_1$ - $C_6$-Alkyl-, $C_1$-$C_6$-Alkoxy- oder $C_1$-$C_6$-Alkylthiogruppen, Carboxyl-oder Alkoxycarbonylgruppen substituierter Phenylrest ist,
   $R^2$ ein $C_1$ - $C_6$-Alkyl-, ein 5- oder 6-Ring-Cycloalkylrest, ein aliphatischer $C_1$ -$C_6$-Acyl- oder ein gegebenenfalls substituierter Benzoylrest ist,
   $R^3$ und $R^4$ die gleiche Bedeutung wie $R^1$ haben, wobei $R^1$, $R^3$ und $R^4$ gleich oder verschieden sein können und
   $X^{\ominus}$ ein nicht-nucleophiles Anion ist.

2. Härtbare Mischungen nach Anspruch 1, <u>dadurch gekennzeichnet</u>, daß $X^{\ominus}$ ein Anion der Formel (II)

   $[MY_nZ_m]^{\ominus}$ II

   oder $CF_3SO_3^{\ominus}$ oder $ClO_4^{\ominus}$ ist,
   wobei M für ein Bor-, Wismut-, Antimon-, Arsen- oder Phosphoratom, Y für Fluor und/oder Chlor, Z für eine Hydroxylgruppe steht und m für die Zahlen 0 oder 1, n für die Zahlen 4 - 6 steht mit der Maßgabe, daß die Summe aus m und n jeweils um eins höher ist als die Wertigkeit von M.

3. Härtbare Mischungen gemäß Anspruch 1 oder Anspruch 2, <u>dadurch gekennzeichnet</u>, daß sie als Härtungskatalysator ein N-Sulfonylaminosulfoniumsalz der Formel (I) enthalten, wobei $R^1$ einen Phenyl- oder $C_1$-$C_4$-Alkylphenylrest, $R^2$ einen $C_1$-$C_4$-Alkylrest, $R^3$ und $R^4$, gleich oder verschieden,einen $C_1$-$C_4$-Alkylrest, Phenylrest oder $C_1$-$C_4$-Alkylphenylrest darstellen und $X^{\ominus}$ ein Anion der Formel (II) gemäß Anspruch 2 ist.

4. Härtbare Mischungen nach einem der Ansprüche 1 - 3, <u>dadurch gekennzeichnet</u>, daß sie zusätzlich ein Oxidationsmittel aus der Klasse der gegebenenfalls substituierten Chinone oder der Klasse der organischen Peroxide enthalten.

5. Härtbare Mischungen nach einem der Ansprüche 1 bis 4, <u>dadurch gekennzeichnet</u>, daß sie als härtbare Verbindungen a) ein 1,2-Epoxid, eine olefinisch ungesättigte Verbindung, ein Aminoplast oder ein Phenoplast enthalten.

6. Härtbare Mischungen nach einem der Ansprüche 1 bis 5, <u>dadurch gekennzeichnet</u>, daß sie den Härtungskatalysator b) in einer Menge von 0,1 bis 15 Gew. % der Verbindungen a) enthalten

7. Härtbare Mischungen gemäß Anspruch 4, <u>dadurch gekennzeichnet</u>, daß sie ein Oxidationsmittel in einer Menge von 0,01 bis 10 Gew. % der Menge an Verbindungen a) enthalten.

8. Verfahren zur Herstellung von gehärteten Formkörpern oder Oberflächenbeschichtungen aus härtbaren Mischungen gemäß einem der Ansprüche 1 bis 7, <u>dadurch gekennzeichnet</u>, daß man die Mischungen auf Temperaturen von 80 bis 160 °C erwärmt.

9. Verfahren zur Herstellung von gehärteten Formkörpern oder Oberflächenbeschichtungen aus härtbaren

Mischungen gemäß einem der Ansprüche 1 bis 7, dadurch gekennzeichnet, daß man die Mischungen durch Bestrahlung mit Licht der Wellenlänge 200 - 600 nm aushärtet.

**10.** Für die Herstellung von Reliefbildern oder Resistmustern geeignetes lichtempfindliches Aufzeichnungsmaterial mit einer auf einem dimensionsstabilen Träger aufgebrachten lichtempfindlichen härtbaren Schicht (S), enthaltend

(i) mindestens eine Verbindung mit mindestens zwei aromatischen und/oder heteroaromatischen o-Nitrocarbinolestergruppierungen der Formel

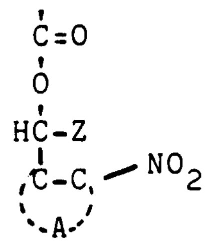

worin A den Rest eines aromatischen oder heteroaromatischen, gegebenenfalls substituierten Ringsystems mit 5 bis 15 Ringgliedern und Z ein Wasserstoffatom, einen Alkylrest mit 1 bis 8 Kohlenstoffatomen oder einen gegebenenfalls substituierten Aryl- oder Aralkylrest bedeuten,

(ii) mindestens eine vernetzend wirkende Verbindung mit mindestens zwei reaktiven Gruppen, die unter dem Einfluß von Wärme mit -COOH-Gruppen unter Bildung einer kovalenten chemischen Bindung zu reagieren vermögen, wobei (ii) auch als Gruppierung(en) in den Verbindungen (i) enthalten sein kann,

(iii)mindestens ein N-Sulfonylaminosulfoniumsalz der in Anspruch 1 angegebenen Formel (I).

**Claims**

**1.** A curable mixture containing

a) one or more compounds which, under the influence of a cationic catalyst, are convertible into a higher molecular weight compound, and

b) a curing catalyst of the formula (I)

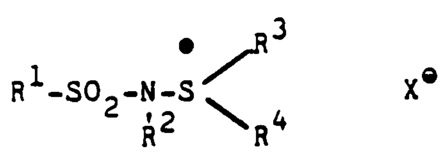

(I),

where $R^1$ is $C_1$-$C_{18}$-alkyl, 5- or 6-ring-cycloalkyl or phenyl which may be substituted by chlorine or bromine atoms, $C_1$-$C_6$-alkyl, $C_1$-$C_6$-alkoxy or $C_1$-$C_6$-alkylthio groups or carboxyl or alkoxy-carbonyl groups,

$R^2$ is $C_1$-$C_6$-alkyl, 5- or 6-ring-cycloalkyl, aliphatic $C_1$-$C_6$-acyl or substituted or unsubstituted benzoyl,

$R^3$ and $R^4$ each have the same meanings as $R^1$ and can be identical to or different from $R^1$ and each other, and $X^\ominus$ is a nonnucleophilic anion.

**2.** A curable mixture as claimed in claim 1, wherein $X^\ominus$ is an anion of the formula (II)

$[MY_nZ_m]^\ominus$ (II)

or $CF_3SO_3^\ominus$ or $ClO_4^\ominus$, where M is boron, bismuth, antimony, arsenic or phosphorus, Y is fluorine or chlorine,

Z is hydroxyl, m is 0 or 1 and n is 4 - 6, with the proviso that the total of m and n is in each case greater by one than the valence of M.

**3.** A curable mixture as claimed in claim 1 or 2, which contains as curing catalyst an N-sulfonylaminosulfonium salt of the formula (I) where $R^1$ is phenyl or $C_1$-$C_4$-alkylphenyl, $R^2$ is $C_1$-$C_4$-alkyl, $R^3$ and $R^4$,

identical or different, are each $C_1$-$C_4$-alkyl, phenyl or $C_1$-$C_4$-alkylphenyl and $X^{\ominus}$ is an anion of the formula (II) as claimed in claim 2.

**4.** A curable mixture as claimed in any of claims 1 to 3, which additionally contains an oxidizing agent from the class of the substituted or unsubstituted quinones or from the class of the organic peroxides.

**5.** A curable mixture as claimed in any of claims 1 to 4, which contains as curable compound a) a 1,2-epoxide, an olefinically unsaturated compound, an amino resin or a phenolic resin.

**6.** A curable mixture as claimed in any of claims 1 to 5, which contains the curing catalyst b) in an amount of from 0.1 to 15% by weight of compound(s) a).

**7.** A curable mixture as claimed in claim 4, which contains an oxidizing agent in an amount of from 0.01 to 10% by weight of the amount of compound(s) a).

**8.** A process for preparing a cured molding or surface coating from a curable mixture as claimed in any of claims 1 to 7, which comprises heating the mixture to 80 - 160 ° C.

**9.** A process for preparing a cured molding or surface coating from a curable mixture as claimed in any of claims 1 to 7, which comprises curing the mixture by irradiation with light of wavelength 200 - 600 nm.

**10.** A light-sensitive recording material suitable for the production of relief images or resist patterns comprising, applied to a dimensionally stable substrate, a light-sensitive curable layer (L) containing

(i) one or more compounds having two or more aromatic and/or hetaromatic o-nitrocarbinol ester groups of the formula

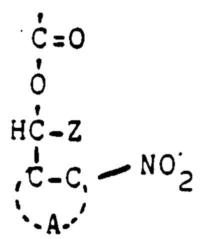

where A is the radical of an aromatic or heteromatic, substituted or unsubstituted ring system of 5 to 15 ring members and Z is hydrogen, alkyl of 1 to 8 carbon atoms or substituted or unsubstituted aryl or aralkyl,

(ii) one or more crosslinking compounds which have two or more reactive groups capable of reaction, by the action of heat, with -COOH groups to form a covalent chemical bond and which can also be present as groups in compounds (i), and

(iii) one or more N-sulfonylaminosulfonium salts of the formula (I) indicated in claim 1.

**Revendications**

**1.** Mélanges durcissables contenant :

a) au moins un composé convertible en un composé à poids moléculaire plus élevé sous l'influence d'un catalyseur cationique, et

b) un catalyseur de durcissement de formule I

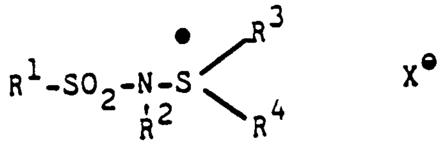

(I),

dans laquelle $R^1$ représente un groupe alkyle en C 1-C 18, un groupe cycloalkyle à 5 ou 6 chaînons ou un groupe phényle éventuellement substitué par des atomes de chlore ou de brome, des groupes

alkyle en C 1-C 6, alcoxy en C 1-C 6 ou alkylthio en C 1-C 6, des groupes carboxyle ou alcoxycarbonyle,
$R^2$ représente un groupe alkyle en C 1-C 6, un groupe cycloalkyle à 5 ou 6 chaînons, un groupe acyle aliphatique en C 1-C 6 ou un groupe benzoyle éventuellement substitué,
$R^3$ et $R^4$ ont les mêmes significations que $R^1$, mais $R^1$, $R^3$ et $R^4$ peuvent être identiques ou différents, et
$X^{\ominus}$ représente un anion non-nucléophile.

**2.** Mélanges durcissables selon la revendication 1, caractérisés en ce que $X^{\ominus}$ est un anion de formule II

$$[MY_nZ_m]^{\ominus} \qquad II$$

ou $CF_3SO_3^{\ominus}$ ou $ClO_4^{\ominus}$,
M représentant un atome de bore, de bismuth, d'antimoine, d'arsenic ou de phosphore,
Y représentant le fluor et/ou le chlore, Z un groupe hydroxy et m est égal à 0 ou 1,
n est un nombre allant de 4 à 6, sous réserve que la somme de m et n est dans tous les cas supérieure de 1 à la valence de M.

**3.** Mélanges durcissables selon la revendication 1 ou 2, caractérisé en ce qu'ils contiennent en tant que catalyseur de durcissement un sel de N-sulfonylaminosulfonium de formule I dans laquelle $R^1$ représente un groupe phényle ou (alkyle en C 1-C 4)-phényle, $R^2$ représente un groupe alkyle en C 1-C 4, $R^3$ et $R^4$, ayant des significations identiques ou différentes, représentent chacun un groupe alkyle en C 1-C 4 phényle ou (alkyle en C 1-C 4)-phényle et $X^{\ominus}$ est un anion de formule II de la revendication 2.

**4.** Mélanges durcissables selon l'une des revendications 1 à 3, caractérisés en ce qu'ils contiennent en outre un agent oxydant choisi dans la classe des quinones éventuellement substituées ou dans la classe des peroxydes organiques.

**5.** Mélanges durcissables selon l'une des revendications 1 à 4, caractérisés en ce qu'ils contiennent en tant que composé durcissable a) un 1,2-époxyde, un composé à insaturation oléfinique, un aminoplaste ou un phénoplaste.

**6.** Mélanges durcissables selon l'une des revendications 1 à 5, caractérisés en ce que le catalyseur de durcissement b) est un contenu en quantité de 0,1 à 15 % du poids des composés a).

**7.** Mélanges durcissables selon la revendication 4, caractérisés en ce qu'ils contiennent un agent oxydant en quantité de 0,01 à 10 % du poids des composés a).

**8.** Procédé de préparation de corps moulés durcis ou d'application de revêtements superficiels consistant en mélanges durcissables selon l'une des revendications 1 à 7, caractérisé en ce que l'on chauffe les mélanges à des températures de 80 à 160 degrés C.

**9.** Procédé de préparation de corps moulés durcis ou d'application de revêtement superficiels consistant en mélanges durcissables selon une des revendications 1 à 7, caractérisé en ce que l'on durcit les mélanges par exposition à de la lumière de longueur d'ondes 200 à 600 nm.

**10.** Matériau d'enregistrement photosensible convenant à la formation d'images en relief ou de modèles de réserve, comprenant, appliquée sur un support à dimensions stables, une couche (S) photosensible durcissable contenant :
(i) au moins un composé contenant au moins deux groupements ester d'o-nitrocarbinol aromatiques et/ou hétéroaromatiques de formule

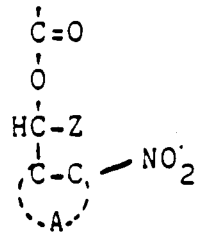

dans laquelle A représente le radical d'un système cyclique aromatique ou hétéroaromatique éventuellement substitué de 5 à 15 chaînons cycliques et Z représente un atome d'hydrogène, un groupe alkyle en C 1-C 8 ou un groupe aryle ou aralkyle éventuellement substitué,

(ii) au moins un composé à effet réticulant à au moins deux groupes réactifs qui, sous l'action de la chaleur, sont capables de réagir avec les groupes -COOH avec formation d'une liaison chimique covalente, ce composant (ii) pouvant également être contenu sous forme d'un ou plusieurs groupements dans les composés (i).

(iii) au moins un sel de N-sulfonylaminsulfonium de formule I de la revendication 1.